# EUROPÄISCHE PATENTSCHRIFT

(11) **EP 0 568 728 B1**
(45) Veröffentlichungstag und Bekanntmachung des Hinweises auf die Patenterteilung: **05.03.1997**
(21) Anmeldenummer: 92117700.2
(22) Anmeldetag: 16.10.1992
(51) Int. Cl.: C25D 5/00, C25D 5/18, H05K 3/42

(54) **Verfahren zum Galvanisieren von mit Lochungen versehenen Werkstücken, sowie Anordnung zur Durchführung dieses Verfahrens**
Process and apparatus for electroplating perforated articles
Procédé et dispositif pour l'électroplacage d'articles perforés

(30) Priorität: 19.10.1991 DE 4134632
(43) Veröffentlichungstag der Anmeldung: 10.11.1993
(73) Patentinhaber: ATOTECH Deutschland GmbH, 10553 Berlin (DE)
(72) Erfinder: Hübel, Egon, W-8501 Feucht (DE)
(74) Vertreter: Effert, Udo, Dipl.-Ing.

(56) Entgegenhaltungen:
- TRANSACTIONS OF THE INSTITUTE OF METAL FINISHING, Bd.69, Februar 1991, GB Seiten 9 - 14 PEARSON 'the effect of pulsed reversed current on the "hole throwing power"of acid copper electrolytes containing organic additives'

## Beschreibung

Die Erfindung geht zunächst aus von einem Verfahren zum Galvanisieren oder dergleichen von mit Lochungen versehenen Werkstücken wie Platten, insbesondere von Leiterplatten, wobei das zu behandelnde Werkstück (Ware) sich zwischen einer ersten und einer zweiten Außenelektrode befindet (Oberbegriff des Anspruches 1). Bisher war es bei galvanotechnischer Anwendung üblich, daß die beiden Außenelektroden zusammen an eine gegenüber dem Werkstück (Ware), das die Funktion einer Innenelektrode hat, positive Spannung gelegt wurden und somit gleichzeitig von beiden Seiten das Werkstück behandelten. Die Praxis hat gezeigt, daß die auf den Innenwandungen der Lochungen entstehende Schicht dünner ist als die Schicht auf den beidseitigen, außen gelegenen Flächen der Platte. Dieses in der Praxis möglichst zu vermeidende Mißverhältnis wurde mit zunehmender Größe der Verhältniszahl "Plattendicke geteilt durch Lochungsdurchmesser" (bis zu Werten von 20:1 und mehr, wobei der Bohrungsdurchmesser Werte bis herab zu 0,2 mm hat) immer stärker. Letztendlich besteht die Gefahr, daß die Lochungsinnenwandung völlig ungenügend mit einer Schicht versehen wird. Um dies zu vermeiden, hat man schon besondere Maßnahmen angewendet, um den Flüssigkeitsaustausch durch die Lochungen hindurch zu verbessern, d.h. um eine möglichst große Menge der Flüssigkeit des Galvanisierbades durch die Lochungen hindurchtreten zu lassen und damit verbesserte Galvanisierbedingungen zu schaffen. Diese Technik in Form einer intensiven Bewegung der Ware und auch einer Lufteinführung zur Bewegung des Bades hat sich zwar bewährt. Auch hat man bisher versucht, dieses Schichtdickenverhältnis dadurch zu verbessern, daß man zwischen den beiden Außenelektroden einen relativ großen Abstand vorsah und mit geringerer Stromdichte über eine längere Galvanisierzeit metallisierte. Dies ist aufwendig. Auch ist man so vorgegangen, daß man so lange metallisierte, bis in der Lochung die vorgeschriebene Mindestschichtdicke erreicht war, wobei toleriert werden mußte, daß die hierbei auf der Warenaußenfläche entstandene Beschichtung dicker als an sich erforderlich wurde. Hierbei sind der hohe Materialverbrauch, die Ungenauigkeit in der Schichtdicke sowie die längere Behandlungszeit nachteilig. Es sind auch langwierige chemische Optimierungen des Elektrolyten zur Verbesserung des beschriebenen Problemes durchgeführt worden. Abgesehen von dem hiermit verbundenen Aufwand war das Ergebnis nicht befriedigend. Insgesamt konnte mit den bisher bekannten Maßnahmen, insbesondere bei den vorstehend erwähnten extrem ungünstigen Abmessungen von Bohrungsdurchmesser und Plattendicke, nicht, zumindest nicht genügend genau und wirtschaftlich, die gewünschte Angleichung der Schichtdicke in den Lochungen zur Schichtdicke an den Plattenaußenflächen erreicht werden.

Zur Erzielung bestimmter Oberflächenstrukturen oder homogener Metallschichten ist ein beispielsweise aus US-PS 4666567 bekanntes Verfahren üblich. Hierbei werden während einer Periode beide Seiten des Werkstückes gleichzeitig metallisiert, während in der nachfolgenden Periode beide Seiten des Werkstückes zugleich entmetallisiert werden und dies alternierend fortgesetzt wird. Hiermit ist aber weder die nachstehend angegebene Aufgabenstellung der Erfindung gelöst, noch betrifft dies das erfindungsgemäße Verfahren und die erfindungsgemäße Anordnung zur Durchführung des Verfahrens.

Die Aufgaben- bzw. Problemstellung der vorliegenden Erfindung besteht daher zunächst, ausgehend vom eingangs genannten Oberbegriff des Anspruches 1, darin, das Verhältnis der Dicke der vom Materialauftrag gebildeten Schicht auf den Plattenaußenflächen zur Dicke der Schicht an den Innenwänden der Lochungen günstiger zu gestalten, d.h. in Richtung zum Wert 1:1 hin.

Die Lösung dieser Aufgabe wird zunächst darin gesehen, das Verfahren gemäß Oberbegriff des Anspruches 1 so zu gestalten, daß zeitlich nacheinander und sich abwechselnd die nachstehenden Betriebsperioden erfolgen:
a. eine erste Periode, in der im Bezug auf die Ware die erste Außenelektrode metallisierend, und die zweite Außenelektrode entmetallisierend betrieben wird,
b. eine zweite Periode, in der im Bezug auf die Ware die erste Außenelektrode entmetallisierend, und die zweite Außenelektrode metallisierend betrieben wird,
und daß der Effekt der jeweiligen Entmetallisierung gegenüber der zugehörigen Metallisierung der gleichen Periode reduziert wird.

Während jeder Periode entsteht zwischen der ersten und der zweiten Außenelektrode eine Gesamtspannung, welche gleich der Summe aus der Spannung zwischen der ersten Außenelektrode und der Ware, sowie der Spannung zwischen der Ware und der zweiten Außenelektrode ist. Die Ware hat dabei in beiden Perioden a und b die Funktion einer Innenelektrode. Mit der Erfindung wird gegenüber den bekannten Maßnahmen nach dem Stand der Technik eine größere Spannung zwischen den beiden Außenelektroden erzielt, womit eine entsprechend große Beschleunigung der Ionen erreicht wird. Diese größere Spannung verstärkt nach Erkenntnis der Erfindung zum einen den Grad der Metallisierung an der Innenwand der Lochung. Die vorstehend erläuterte größere Spannung zwischen den beiden Außenelektroden hat zum zweiten den weiteren Effekt zur Folge, daß innerhalb der Lochungen an deren Innenwand weniger Material entmetallisiert wird als auf den Außenflächen der Ware. Somit wird im Verhältnis an der Lochungsinnenwandung mehr aufgetragen als auf den Außenflächen der Ware. Die wechselnde Polung vom Betriebszustand der ersten Periode zu dem der zweiten Periode und umgekehrt bewirkt ferner, daß die Metallisierung der Lochung über deren gesamte Länge etwa gleich dick wird. Dies erklärt sich daraus, daß die Metallisierung der Lochungsinnenwand stets in dem Bereich am größten ist, der der jeweils metallisierend betriebenen Außenelektrode zugewandt ist. Dies um so mehr, als die dabei entmetallisierend betriebene Außenelektrode von dem ihr zugewandten Bereich der Lochungsinnenwand dort schon vorhandene Metallisierung teilweise abträgt. Aufgrund des beschriebenen Polungswechsels wird entsprechend abwechselnd der eine Endbereich und der andere Endbereich der Lochung entsprechend stärker metallisiert, wodurch sich die erläuterte Egalisierung des Metallisierungsauftrages über die Lochungslänge ergibt. Um zu verhindern, daß durch die Entmetallisierung der Effekt der Metallisierung aufgehoben wird, ist die beanspruchte Reduzierung der jeweiligen Entmetallisierung gegenüber der zugehörigen Metallisierung vorgesehen, und zwar bei jeder der beiden Perioden. Dies addiert sich zu dem o.g. Effekt, daß die erläuterte größere Spannung zwischen den beiden Außenelektroden einen größeren Metallauftrag auf der Lochungsinnenwandung als auf der Warenaußenfläche bewirkt.

Die geringere Effizienz der Entmetallisierung in der jeweiligen Periode kann durch unterschiedliche Maßnahmen erreicht werden. Hierzu wird auf die Ansprüche 4 und 5 verwiesen, wobei gegebenenfalls die Verfahrensmaßnahmen des Anspruches 4 und die des Anspruches 5 miteinander kombiniert werden können. Der o.g. Effekt, wonach durch das jeweilige Entmetallisieren ein stärkerer Abtrag der Schicht an der Warenaußenfläche und nur ein demgegenüber geringerer Abtrag an der Innenwand der Lochungen geschieht, trägt mit zur Lösung der Aufgabenstellung der Erfindung bei, das Verhältnis der Schichtdicke an der Warenaußenfläche zur Schichtdicke an der Lochungsinnenwand dem Wert 1:1 zu nähern. Im Ergebnis läßt sich ein Schichtdickenverhältnis erreichen, das nahezu gleich 1 ist.

Von Ausnahmefällen abgesehen wird bevorzugt mit der Erfindung angestrebt, daß beide Außenflächen einer Ware, insbesondere einer Ware in Form einer Platte, eine gleich dicke Auftragsschicht erhalten sollen. Hierzu sind gemäß der bevorzugten Verfahrensmaßnahme der Erfindung nach Anspruch 2 die beiden im Anspruch 1 genannten, zusammen einen Zyklus bildenden Perioden a und b gleich lang.

Aus Anspruch 3 ergibt sich, daß die Dauer eines aus den beiden Perioden bestehenden Zyklus in einem relativ weiten Bereich verändert werden kann.

Die Merkmale des Anspruches 4 ergeben eine Reduzierung der Entmetallisierung durch entsprechende Änderungen der Einwirkungszeit der jeweils entmetallisierend betriebenen Außenelektrode in Relation zu der Einwirkungszeit der jeweils metallisierend betriebenen Außenelektrode. Die Merkmale des Anspruches 5 sehen eine entsprechende Reduzierung der Entmetallisierung durch Verringerung der Stromdichte der jeweils entmetallisierend betriebenen Außenelektrode gegenüber der Stromdichte vor, welche von der jeweils metallisierend betriebenen Außenelektrode zur Ware fließt.

Der Erfindung liegt weiterhin die Aufgabe zugrunde, eine Anordnung zur Durchführung des vorstehend erläuterten Verfahrens zu schaffen, die praktikabel und nicht aufwendig ist. Hierzu besteht gemäß Anspruch 11 die Erfindung zunächst darin, daß ein erster und ein zweiter Gleichrichter vorgesehen sind, daß der erste Gleichrichter mit seinem Minuspol an die Ware und mit seinem Pluspol an einen ersten Umschalter gelegt ist, daß der zweite Gleichrichter mit seinem Pluspol an der Ware und mit seinem Minuspol an einen zweiten Umschalter gelegt ist, und daß die beiden Umschalter entsprechend der gewünschten Periode abwechselnd an die erste und die zweite Außenelektrode schaltbar sind. Damit sind im wesentlichen Bauelemente verwendbar, die bereits bei bekannten Galvanisieranlagen vorhanden sind, nämlich Halterungen der Ware, zwei Außenelektroden und zwei Gleichrichter, wobei durch die Hinzufügung der beiden Umschalter und entsprechende Schaltverbindungen der erfindungsgemäße Effekt, d.h. die periodische Umschaltung der Außenelektroden vom Metallisierbetrieb auf Entmetallisierbetrieb und umgekehrt erreichbar ist.

Die Merkmale des Anspruches 12 ermöglichen mit einfachen Mitteln, nämlich Einstellung der Ausgangsspannung des betreffenden Gleichrichters, die Reduzierung der Entmetallisierung.

Die Merkmale des Anspruches 14 stellen eine alternative Anordnung zur Durchführung des erfindungsgemäßen Verfahrens dar.

Weitere Vorteile und Merkmale der Erfindung sind den weiteren Unteransprüchen sowie der nachfolgenden Beschreibung und der zugehörigen Zeichnung von erfindungsgemäßen Ausführungsmöglichkeiten zu entnehmen. In der Zeichnung zeigt:
- Fig. 1:: eine Schaltungsanordnung nach der Erfindung im Betrieb der ersten Periode,
- Fig. 2:: die Schaltungsanordnung gemäß Fig. 1 beim Betrieb der zweiten Periode,
- Fig. 3:: in nur teilweiser Darstellung den Bereich einer Ware mit Lochung,
- Fig. 4 und 5:: Diagramme zweier verschiedener Programmabläufe der Metallisierung und Entmetallisierung.

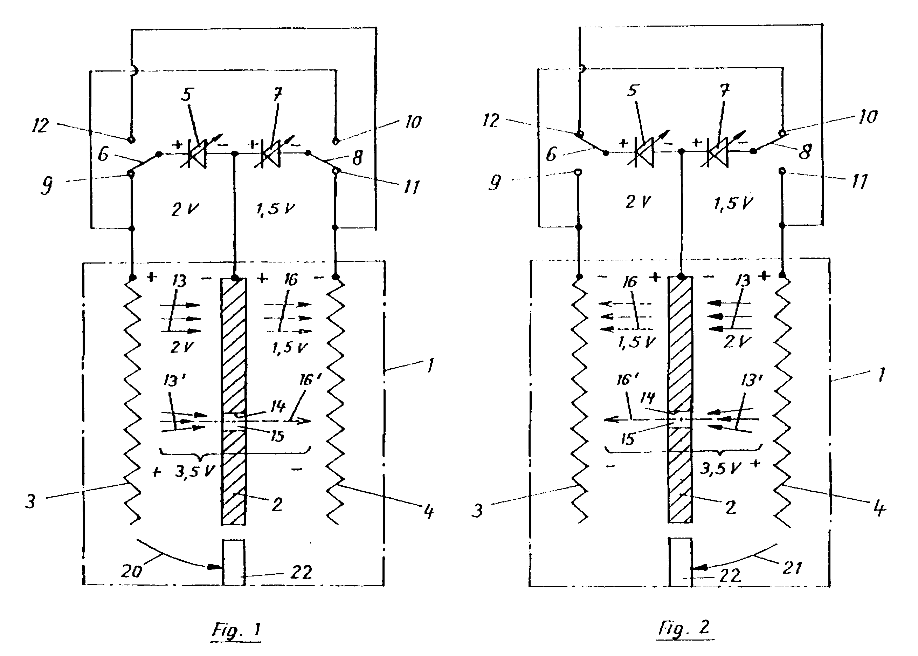

In den Fig. 1 und 2 sind dieselben Bauelemente mit den gleichen Ziffern bezeichnet. In dem strichpunktiert angedeuteten Bad 1 befinden sich die Ware 2 sowie die erste Außenelektrode 3 und die zweite Außenelektrode 4. Es versteht sich, daß innerhalb eines Badbehälters auch mehrere Waren und Außenelektroden vorgesehen sein können als hier der Einfachheit halber nur dargestellt. Ein erster Gleichrichter 5 ist mit seinem Minuspol an die Ware 2 und mit seinem Pluspol an einen ersten Umschalter 6 angeschlossen, während ein zweiter Gleichrichter 7 mit seinem Pluspol an die Ware 2 und mit seinem Minuspol an einen zweiten Umschalter 8 angeschlossen ist. Die erste Außenelektrode 3 ist mit einem Anschluß 9 des ersten Umschalters 6 und mit einem Anschluß 10 des zweiten Umschalters 8 elektrisch verbunden, während die zweite Außenelektrode 4 mit einem Anschluß 11 des zweiten Umschalters und einem Anschluß 12 des ersten Umschalters elektrisch verbunden ist. In der in Fig. 1 dargestellten Schaltstellung der Umschalter 6 und 8 ist die erste Außenelektrode 3 positiv angeschlossen, d.h. sie bewirkt an der Ware eine Metallisierung gemäß den mit durchgehenden Strichen gekennzeichneten Pfeilen 13. Entsprechend den Pfeilen 13' erfolgt eine entsprechende Metallisierung an der Innenwand 14 der Lochung 15. In der Schaltlage gemäß Fig. 1 ist dagegen die zweite Anode 4 an den Minuspol des zweiten Gleichrichters angeschlossen, d.h. sie bewirkt eine Entmetallisierung sowohl der ihr zugewandten Außenfläche der Ware als auch der Lochinnenwand gemäß den gestrichelt dargestellten Pfeilen 16 bzw. 16'. Wie angegeben soll in diesem Beispiel der erste Gleichrichter 5 eine Ausgangsspannung von 2 V und der zweite Gleichrichter 7 eine Ausgangsspannung von 1,5 V haben, so daß sich von der ersten Außenelektrode 3 zur zweiten Außenelektrode 4 eine Spannung von insgesamt 3,5 V ergibt, die wesentlich größer als die Spannung ist, die beim bisher bekannten Verfahren bei gleichen Spannungswerten der Gleichstromquelle zwischen einer der Außenelektroden und der Ware anliegt. Dies bedeutet, daß mit der Erfindung eine wesentlich größere Beschleunigung der Ionen von der einen Außenelektrode 3 bzw. 4 durch die Lochungen 15 hindurch zur anderen Außenelektrode 4 bzw. 3 erfolgt.

Nachdem über eine bestimmte Zeit, d.h. die eingangs genannte erste Periode a, in der Schaltung gemäß Fig. 1 galvanisiert wurde, erfolgt dann der Polungswechsel der Schalter 6, 8 in die Position gemäß Fig. 2, welche der eingangs genannten zweiten Periode b entspricht. Es ist ersichtlich, daß somit die Metallisierung mit den 2 V des ersten Gleichrichters 5 gemäß den Pfeilen 13, 13' jetzt von der zweiten Außenelektrode 4 zur Ware erfolgt, dagegen die Entmetallisierung mit der Spannung 1,5 V des zweiten Gleichrichters 7 gemäß den Pfeilen 16, 16' von der Ware zur ersten Außenelektrode 3, da jetzt in Bezug auf die Ware 2 die zweite Außenelektrode 4 metallisierend und die erste Außenelektrode 3 entmetallisierend betrieben wird.

Durch den erläuterten Unterschied der beiden Gleichrichterspannungen von 2 V und 1,5 V an den beiden Gleichrichtern 5, 7 während der beiden Perioden a und b und die erläuterte Umschaltung wird erreicht, daß jeweils die entmetallisierende Wirkung der betreffenden Außenelektrode kleiner ist als die metallisierende Wirkung der jeweils anderen Außenelektrode, da sich durch die unterschiedlichen Spannungen entsprechend unterschiedliche Stromdichten ergeben. Man kann aber auch die Verringerung der Entmetallisierung in Relation zur gleichzeitig erfolgenden Metallisierung in der Weise erreichen, daß beide Gleichrichter zwar dieselbe Spannung haben, daß aber derjenige Gleichrichter, der in der betreffenden Schaltlage entmetallisierend wirkt, über eine geringere Zeitdauer in Betrieb ist, als der Gleichrichter, der in der betreffenden Schaltlage metallisierend wirkt. Dies kann entweder dadurch geschehen, daß der entmetallisierend wirkende Gleichrichter entweder ganz ausgeschaltet wird, oder gemäß einer bevorzugten Ausführungsform der Erfindung nur einen kleineren Strom, z.B. einen relativ kleinen Strom in Form eines sogenannten Haltestromes liefert. Hierzu wird auch auf die späteren Ausführungen verwiesen. Diese Reduzierung der Entmetallisierung durch entsprechende Zeitschaltungen kann auch mit der Entmetallisierung kombiniert werden, wie sie mittels unterschiedlicher Gleichrichterspannungen zuvor anhand der Fig. 1, 2 erläutert wurde.

Es liegt im Bereich der Erfindung, die Zeitdauer des Zyklus aus den beiden Perioden a und b entweder während der gesamten Behandlungszeit konstant zu halten, oder über die Behandlungszeit zeitlich zu verändern. Das gleiche gilt auch für die erläuterte Verringerung der betreffenden Stromdichte während einer Periode bzw. während eines Zyklus.

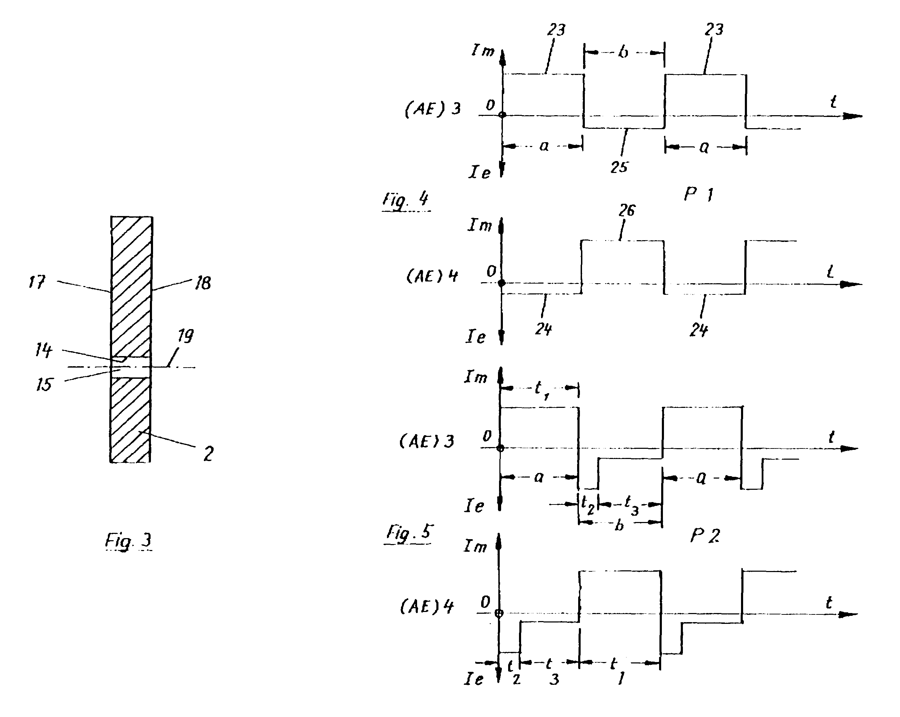

Fig. 3 zeigt in etwas größerem Maßstab die Ware 2 mit Lochung 15 und deren Innenwand 14 sowie den bereits angesprochenen Außenflächen 17, 18 der Ware. Die in der Längsrichtung 19 der Lochung erfolgende Metallisierung ist, falls sie in Fig. 3 von links kommt, an der Außenfläche 17 und an der Innenwand 14 wirksam, und dabei im linken Bereich der Innenwandung 14 mehr als im rechten Bereich; während die entsprechende Entmetallisierung auf die rechts gelegene Außenfläche 18 und primär den rechts gelegenen Bereich der Innenwandung 14 wirkt. Dies wären die Auswirkungen einer Galvanisierung gemäß Schaltlage der Fig. 1. In der Schaltlage der Fig. 2 sind die Auswirkungen auf die Anordnung nach Fig. 3 gegenüber den zuvor geschilderten Wirkungen genau seitenverkehrt. Dabei wirken sich die Phänome aus, daß die jeweilige Entmetallisierung an den Außenflächen 17 bzw. 18 größer ist als an der Innenwand 14; andererseits aber die Metallisierung aufgrund der großen beschleunigenden Spannung an der Innenwand 14 stärker ist als an der Außenfläche 17 bzw. 18, welche der jeweils metallisierend wirkenden Anode zugewandt ist. Wie bereits erwähnt, ist es eine bevorzugte Ausführungsform der Erfindung, daß die beiden Perioden a und b eines Zyklus gleich lang sind. Damit sind die Dicken der Schichten, die über eine Gesamtbehandlung an den Außenflächen 17 und 18 aufgetragen werden, einander gleich groß. Es kann aber Sonderfälle geben, in denen gewünscht wird, daß z.B. die Dicke der auf die Außenfläche 17 aufgetragenen Schicht größer ist als die Dicke der Schicht, welche auf der anderen Außenfläche 18 entsteht. In diesem Fall kann man durch entsprechende Steuerung der Metallisierung einerseits und der Entmetallisierung andererseits, insbesondere auch durch unterschiedliche Zeitdauer der Perioden a und b, das gewünschte Ergebnis erreichen.

Die Erfindung ist sowohl anwendbar bei einer Ware, insbesondere Platte, die vor Beginn der Galvanisierung oder dergleichen an ihren Außenflächen bereits mit einer relativ dünnen Metallschicht versehen ist, als auch bei einer Ware, insbesondere Platte, deren Außenflächen vor Beginn der Galvanisierung oder dergleichen noch gar keine Metallauflage besitzen.

Wie mit Pfeilen 20, 21 angedeutet, wird ein gewisser Galvanisierstrom von dem unteren Bereich der metallisierend wirkenden Außenelektrode zu dem der entmetallisierend wirkenden Außenelektrode verlaufen. Dies kann durch Blenden abgeblockt oder zumindest reduziert werden, wie sie mit Ziffer 22 angedeutet sind.

Die vorstehend bereits erläuterten Möglichkeiten der Reduzierung der jeweiligen Entmetallisierung sind in Form eines Diagrammes und schematisch in den Fig. 4 und 5 dargestellt. Im Beispiel der Fig. 4 wird ein Programm P1 gefahren, wobei die obere Darstellung den metallisierenden Strom Im und den entmetallisierenden Strom Ie zwischen der ersten Außenelektrode (AE) 3 und der Ware zeigt, und zwar über den Zeitablauf t einer Periodenfolge a + b + a. Die darunter befindliche Darstellung zeigt den metallisierenden Strom Im und den entmetallisierenden Strom Ie zwischen der zweiten Außenelektrode (AE) 4 und der Ware, und zwar ebenfalls über die Perioden a + b + a entlang der Zeitachse t. Es ist ersichtlich, daß über eine erste Periode a der Strom Im der ersten Außenelektrode 3 gemäß Ziffer 23 groß ist gegenüber dem zugleich fließenden entmetallisierenden Strom Ie (mit der Ziffer 24) der zweiten Außenelektrode 4. Dagegen ist in der Periode b der entmetallisierende Strom Ie mit der Nummer 25 der ersten Außenelektrode 3 entsprechend kleiner als der metallisierende Strom Im mit der Ziffer 26 der Außenelektrode 4.

Fig. 5 beinhaltet vom Prinzip her die gleiche Darstellungsweise wie Fig. 4. In der oberen Darstellung ist der Stromverlauf zwischen der ersten Außenelektrode (AE) 3 und der Ware, und in der darunter befindlichen Darstellung der Stromverlauf zwischen der zweiten Elektrode (AE) 4 und der Ware über die Zeit t dargestellt. Bei diesem Programm P2 fließt ein metallisierender Strom Im während der ersten Periode a von der Außenelektrode 3 zur Ware, und zwar über einen Zeitraum t1 = a. Zugleich fließt ein entmetallisierender Strom Ie von der zweiten Außenelektrode 4 zur Ware über eine kurze Teilperiode t2 mit einem relativ großen Ampèrebetrag , der aber nicht größer als der vorgenannte Metallisierungsstrom Im sein sollte. Dagegen hat in einer weiteren Teilperiode t3 der Strom Ie einen relativ niedrigen Ampèrebetrag. Dabei ist t1 = t2 + t3. Es besteht also während dieser Periode a ein metallisierender Betrieb zwischen der Außenelektrode 3 und der Ware mit entsprechend großem Stromwert, und ein entmetallisierender Betrieb zwischen der Außenelektrode 4 und der Ware mit demgegenüber zumindest über die Periode t3 kleineren Stromwert. In der sich anschließenden Periode b sind die Stromverläufe gegenüber der Periode a umgekehrt. Von der zweiten Außenelektrode 4 fließt ein relativ großer, metallisierender Strom Im über die Zeit t1 zur Ware, während zugleich von der ersten Außenelektrode 3 zur Ware zunächst über eine kurze Zeit t2 ein relativ großer Entmetallisierungsstrom Ie fließt, der aber nicht größer als der vorgenannte Metallisierungsstrom Im sein sollte, wohingegen in der sich anschließenden Periode t3 der von der Außenelektrode 3 zur Ware fließende Entmetallisierungsstrom Ie relativ klein ist. Auch hier gilt: t1 = t2 + t3.

Der vorgenannte Betrieb mit einem relativ kleinen Strom zumindest über den Zeitabschnitt t3 ist zum einen eine alternative Möglichkeit um zu erreichen, daß die jeweilige Entmetallisierung gegenüber der zugehörigen Metallisierung der gleichen Periode reduziert wird. Außerdem wird hierdurch erreicht, daß der über den Zeitabschnitt t3 fließende, relativ kleine Strom die Funktion eines Haltestromes hat, der nachstehend näher erläutert wird.

Wird während eines Galvanisiervorganges ein Gleichrichter auch nur kurz abgeschaltet, so kann sich dies in der abgeschiedenen Metallisierung als eine veränderte kristalline Schicht auswirken, die zu vermeiden ist. Hierzu kennt man die Aufbringung eines Haltestromes während der o.g. Abschaltzeit, der wesentlich geringer als der Galvanisierstrom ist, aber während dieses Zeitraumes die Bildung der vorgenannten kristallinen Schicht verhindert. Ein derartiger Haltestrom kann auch beim Verfahren nach der Erfindung aufgebracht werden. Dies kann man nicht nur anhand der Fig. 5 erläuterten Betriebsweise, sondern bespielsweise bei einer Schaltanordnung laut Fig. 1, 2 dadurch erreichen, daß die Umschaltung zwischen den beiden Gleichrichtern 5, 7 und den Außenelektroden und damit deren Polwechsel nicht gleichzeitig, sondern zeitlich im Millisekundenbereich versetzt nacheinander derart erfolgt, daß z.B. in der Schaltlage der Fig. 1 die Betätigung des Umschalters 8 etwas früher erfolgt als die des Umschalters 6, und im Fall der Fig. 2 die Betätigung des Umschalters 6 etwas früher geschieht als die des Umschalters 8. Dies ist bei den üblichen elektronischen Gleichrichtern leicht und exakt realisierbar, wodurch im übrigen auch mögliche Stromspitzen begrenzt werden. Dabei empfiehlt sich eine elektronische Umschaltung besonders dann, wenn die Perioden a, b relativ kurz sind. Die in der Zeichnung dargestellten mechanischen Umschalter könnten eher dann eingesetzt werden, wenn die Perioden a, b relativ lang sind. Durch die im Bad praktisch immer vorhandenen niederohmigen Widerstände R wird somit ein stromloser Zustand auf beiden Seiten der Ware vermieden.

Die Erfindung ist auch in anderer, in der Zeichnung nicht dargestellter Weise zu verwirklichen, indem auf die Umschalter 6, 8 verzichtet wird und einer der Gleichrichter elektrisch fest an die erste Außenelektrode 3 und die Ware und der andere der beiden Gleichrichter elektrisch fest an die zweite Außenelektrode 4 und die Ware angeschlossen wird. Der erfindungsgemäße Betrieb (siehe insbesondere Anspruch 1) kann dann durch Steuerung der jeweiligen Polarität der Gleichrichter, der Höhe des jeweils von den Gleichrichtern gelieferten Stromes und der jeweiligen Zeitdauer der Stromlieferung der Gleichrichter erreicht werden.

Erforderlichenfalls kann man den vorstehend beschriebenen Verfahren und Anordnung des Galvanisierens mit Polwechsel vorausgehend oder anschließend das bisher übliche gleichzeitige und beidseitige Metallisieren vorsehen. Hiermit können z.B. in der Anfangsphase besondere physikalische Eigenschaften der Schicht, wie Haftfestigkeit, erzielt werden, sofern dies gewünscht wird. Auch kann man das Verfahren nach der Erfindung kombinieren mit einem vor- oder nachgeschalteten bisher üblichen gleichzeitigen Entmetallisieren. Dies dient (sofern erforderlich) in der Endphase der Schaffung einer besonderen Oberflächenbeschaffenheit wie Glanz, Rauhigkeit oder Lötfähigkeit. Unterkombinationen der zuletzt erläuterten Maßnahmen sind möglich.

## Patentansprüche

1. Verfahren zum Galvanisieren von mit Lochungen versehenen Werkstücken wie Platten, insbesondere Leiterplatten, wobei das zu behandelnde Werkstück (Ware) sich zwischen einer ersten und einer zweiten Außenelektrode befindet, dadurch gekennzeichnet, daß zeitlich nacheinander und sich abwechselnd die nachstehenden Betriebsperioden erfolgen:
a. eine erste Periode (a), in der in Bezug auf die Ware (2) die erste Außenelektrode (3) metallisierend und die zweite Außenelektrode (4) entmetallisierend betrieben wird,
b. eine zweite Periode (b), in der in Bezug auf die Ware (2) die erste Außenelektrode (3) entmetallisierend und die zweite Außenelektrode (4) metallisierend betrieben wird,
und daß die jeweilige Entmetallisierung gegenüber der zugehörigen Metallisierung der gleichen Periode reduziertwird.

2. Verfahren nach Anspruch 1, dadurch gekennzeichnet, daß die beiden vorgenannten, zusammen einen Zyklus bildenden Perioden (a, b) gleich lang sind.

3. Verfahren nach Anspruch 1 oder 2, dadurch gekennzeichnet, daß jede der Perioden (a, b) sich über einen Zeitraum von einer Sekunde bis mehrere Minuten erstreckt.

4. Verfahren nach einem der Ansprüche 1 oder 3, dadurch gekennzeichnet, daß die Reduzierung der Entmetallisierung gegenüber der Metallisierung durch Verringerung der effektiven Zeitdauer des entmetallisierenden Betriebes gegenüber der effektiven Zeitdauer des metallisierenden Betriebes der gleichen Periode erfolgt.

5. Verfahren nach einem der Ansprüche 1 bis 4, dadurch gekennzeichnet, daß die Reduzierung der Entmetallisierung gegenüber der Metallisierung durch eine geringere Stromdichte des entmetallisierenden Betriebes gegenüber der Stromdichte des metallisierenden Betriebes während der gleichen Periode erfolgt.

6. Verfahren nach Anspruch 4 und 5, gekennzeichnet durch die Kombination einer zeitlichen Steuerung und einer Steuerung der Stromdichten zwecks Reduzierung der Entmetallisierung gegenüber der Metallisierung.

7. Verfahren nach einem der Ansprüche 1 bis 6, dadurch gekennzeichnet, daß zusätzlich zu dem alternierenden Betrieb den o.g. Perioden (a, b) Metallisierungsphasen vorgeschaltet und/oder nachgeschaltet sind, in denen beide Außenelektroden (3, 4) metallisierend betrieben werden.

8. Verfahren nach einem der Ansprüche 1 bis 6, dadurch gekennzeichnet, daß zusätzlich zu dem alternierenden Betrieb den o.g. Perioden (a, b) Entmetallisierungsphasen vorgeschaltet und/oder nachgeschaltet sind, in denen beide Außenelektroden (3, 4) entmetallisierend betrieben werden.

9. Verfahren nach einem der Ansprüche 1 bis 8, dadurch gekennzeichnet, daß die Zeitdauer eines Zyklus während der gesamten Behandlungszeit eines Galvanisiervorganges konstant gehalten oder über die Behandlungszeit verändert wird.

10. Verfahren nach einem der Ansprüche 4 bis 9, dadurch gekennzeichnet, daß die Parameter der Reduzierung der Entmetallisierung gegenüber der Metallisierung einstellbar sind und erforderlichenfalls über den Ablauf eines Zyklus zeitlich veränderbar sind.

11. Anordnung zur Durchführung des Verfahrens nach einem der Ansprüche 1 bis 10, dadurch gekennzeichnet, daß ein erster (5) und ein zweiter (7) Gleichrichter vorgesehen ist, daß der erste Gleichrichter mit seinem Minuspol an die Ware und mit seinem Pluspol an einen ersten Umschalter (6) angeschlossen ist, daß der zweite Gleichrichter mit seinem Pluspol an die Ware (2) und mit seinem Minuspol an einen zweiten Umschalter (8) angeschlossen ist, und daß die Umschalter (6, 8) entsprechend der gewünschten Periode (a, b) abwechselnd an die erste (3) oder die zweite (4) Außenelektrode schaltbar sind.

12. Anordnung nach Anspruch 11, dadurch gekennzeichnet, daß die Ausgangsspannung des ersten Gleichrichters (5) größer ist als die Ausgangsspannung des zweiten Gleichrichters (7), daß während der ersten Periode (a) der erste Gleichrichter (5) an die erste Außenelektrode (3) und der zweite Gleichrichter (7) an die zweite Außenelektrode (4) geschaltet ist, und daß während der zweiten Periode (b) der erste Gleichrichter (5) an die zweite Außenelektrode (4) und der zweite Gleichrichter (7) an die erste Außenelektrode (3) geschaltet ist.

13. Anordnung nach Anspruch 11 oder 12, dadurch gekennzeichnet, daß während der Umschaltphase von einer Periode (a) zur anderen Periode (b) und umgekehrt eine Steuerung derart vorgesehen ist, daß sich die Zuschaltung der Gleichrichter in dem Sinne zeitlich überlappt, daß keine Stromlücke entsteht, d.h. durch das Bad ein Haltestrom fließt.

14. Anordnung zur Durchführung des Verfahrens nach einem der Ansprüche 1 bis 10, dadurch gekennzeichnet, daß ein erster und ein zweiter Gleichrichter vorgesehen ist, daß jeder dieser Gleichrichter einerseits an die Ware und andererseits an eine von zwei Außenelektroden elektrisch angeschlossen ist, und daß zur Durchführung der erfindungsgemäßen Verfahrensmaßnahmen die jeweilige Polarität der Gleichrichter, die Stärke der jeweils von ihnen gelieferten Ströme und die Zeitdauer der Lieferung des jeweiliegen Stromes je für sich oder in Kombination einstellbar sind.

15. Anordnung nach einem der Ansprüche 11 bis 14, dadurch gekennzeichnet, daß zusätzlich zum ersten und zum zweiten Gleichrichter (5) bzw. (7) ein oder mehrere Haltegleichrichter für die Aufrechterhaltung eines Haltestromes während der gesamten Behandlungszeit vorgesehen ist bzw. sind.

## Claims

1. Method of electroplating workpieces which are provided with perforations, such as boards, more especially printed circuit boards, the workpiece (article) to be treated being situated between a first outer electrode and a second outer electrode, characterised in that the below-mentioned operational periods occur in succession per unit time and alternately:
a. a first period (a), in which the first outer electrode (3) is operated in a plating manner relative to the article (2), and the second outer electrode (4) is operated in a deplating manner relative thereto,
b. a second period (b), in which the first outer electrode (3) is operated in a deplating manner relative to the article (2), and the second outer electrode (4) is operated in a plating manner relative thereto,
and in that the respective deplating is reduced vis-à-vis the associated plating of the same period.

2. Method according to claim 1, characterised in that the two above-mentioned periods (a, b), which together form a cycle, are the same length.

3. Method according to claim 1 or 2, characterised in that each of the periods (a, b) extends over an interval ranging from one second to several minutes.

4. Method according to one of claims 1 or 3, characterised in that the reduction in the deplating vis-à-vis the plating is achieved by reducing the effective duration of the deplating operation vis-à-vis the effective duration of the plating operation of the same period.

5. Method according to one of claims 1 to 4, characterised in that the reduction in the deplating vis-à-vis the plating is achieved by a smaller current density of the deplating operation vis-à-vis the current density of the plating operation during the same period.

6. Method according to claim 4 and 5, characterised by the combination of a time control and a control of the current densities for the purpose of reducing the deplating vis-à-vis the plating.

7. Method according to one of claims 1 to 6, characterised in that, in addition to the alternating operation, plating phases are connected before and/or after the above-mentioned periods (a, b), both outer electrodes (3, 4) being operated in a plating manner in said phases.

8. Method according to one of claims 1 to 6, characterised in that, in addition to the alternating operation, deplating phases are connected before and/or after the above-mentioned periods (a, b), both outer electrodes (3, 4) being operated in a deplating manner in said phases.

9. Method according to one of claims 1 to 8, characterised in that the duration of a cycle is kept constant during the entire treatment time of an electroplating process or is changed over the treatment time.

10. Method according to one of claims 4 to 9, characterised in that the parameters for reducing the deplating vis-à-vis the plating are adjustable and, if necessary, they are changeable per unit time during the course of a cycle.

11. Arrangement for accomplishing the method according to one of claims 1 to 10, characterised in that a first rectifier (5) and a second rectifier (7) are provided, in that the first rectifier is connected to the article by its negative pole and to a first changeover switch (6) by its positive pole, in that the second rectifier is connected to the article (2) by its positive pole and to a second changeover switch (8) by its negative pole, and in that the changeover switches (6, 8) are alternately switchable to the first outer electrode (3) or to the second outer electrode (4) according to the desired period (a, b).

12. Arrangement according to claim 11, characterised in that the output voltage of the first rectifier (5) is greater than the output voltage of the second rectifier (7), in that, during the first period (a), the first rectifier (5) is switched to the first outer electrode (3) and the second rectifier (7) is switched to the second outer electrode (4), and in that, during the second period (b), the first rectifier (5) is switched to the second outer electrode (4) and the second rectifier (7) is switched to the first outer electrode (3).

13. Arrangement according to claim 11 or 12, characterised in that, during the changeover phase from one period (a) to the other period (b) and vice versa, a control is provided such that the connection of the rectifiers overlaps per unit time in the sense that no break in the current is produced, i.e. a retaining current flows through the bath.

14. Arrangement for accomplishing the method according to one of claims 1 to 10, characterised in that a first rectifier and a second rectifier are provided, in that each of these rectifiers is electrically connected, at one end, to the article and, at the other end, to one of two outer electrodes, and in that, to accomplish the method steps of the invention, the respective polarity of the rectifiers, the intensity of the currents respectively supplied thereby, and the duration for supplying the respective current are adjustable individually or in combination.

15. Arrangement according to one of claims 11 to 14, characterised in that, in addition to the first rectifier (5) and the second rectifier (7), one or more retaining rectifiers is or are provided for maintaining a retaining current during the entire treatment time.

## Revendications

1. Procédé pour l'électroplacage de pièces pourvues de perforations telles que des plaques, en particulier des cartes imprimées, la pièce à traiter (article) se trouvant entre une première électrode extérieure et une deuxième électrode extérieure, caractérisé en ce que les périodes de service ci-dessous s'effectuent chronologiquement successivement et alternativement :
a. Une première période (a) au cours de laquelle la première électrode extérieure (3) est utilisée pour la métallisation et la deuxième électrode extérieure (4) pour la démétallisation par rapport à l'article (2)
b. Une deuxième période (b) au cours de laquelle la première électrode extérieure (3) est utilisée pour la démétallisation et la deuxième électrode extérieure (4) pour la métallisation par rapport à l'article (2), et en ce que la démétallisation concernée est réduite par rapport à la métallisation correspondante de la même période.

2. Procédé selon la revendication 1, caractérisé en ce que les deux périodes (a, b) précitées, formant ensemble un cycle, sont de même longueur.

3. Procédé selon la revendication 1 ou 2, caractérisé en ce que chacune des périodes (a, b) s'étend sur un laps de temps allant d'une seconde à plusieurs minutes.

4. Procédé selon l'une des revendications 1 ou 3, caractérisé en ce que la réduction de la démétallisation par rapport à la métallisation s'effectue par la réduction de la durée effective du service de démétallisation par rapport à la durée effective du service de métallisation de la même période.

5. Procédé selon l'une quelconque des revendications 1 à 4, caractérisé en ce que la réduction de la démétallisation par rapport à la métallisation s'effectue par une densité de courant plus faible du service de démétallisation par rapport à la densité de courant du service de métallisation au cours de la même période.

6. Procédé selon les revendications 4 et 5, caractérisé par la combinaison d'une commande du temps et d'une commande des densités de courant afin de réduire la démétallisation par rapport à la métallisation.

7. Procédé selon l'une quelconque des revendications 1 à 6, caractérisé en ce que, en supplément du service en alternance, on intercale avant et/ou après les périodes (a, b) susmentionnées des phases de métallisation au cours desquelles les deux électrodes extérieures (3, 4) sont utilisées pour une métallisation.

8. Procédé selon l'une quelconque des revendications 1 à 6, caractérisé en ce que, en supplément du service en alternance, on intercale avant et/ou après les périodes (a, b) susmentionnées des phases de démétallisation au cours desquelles les deux électrodes extérieures (3, 4) sont utilisées pour une démétallisation.

9. Procédé selon l'une quelconque des revendications 1 à 8, caractérisé en ce que la durée d'un cycle est maintenue constante pendant toute la durée de traitement d'une opération d'électroplacage ou est modifiée pendant la durée de traitement.

10. Procédé selon l'une quelconque des revendications 4 à 9, caractérisé en ce que les paramètres de la réduction de la démétallisation peuvent être ajustés par rapport à la métallisation et peuvent être modifiés dans le temps pendant le déroulement d'un cycle, si cela s'avère nécessaire.

11. Dispositif pour la mise en oeuvre du procédé selon l'une quelconque des revendications 1 à 10, caractérisé en ce qu'un premier redresseur (5) et un deuxième redresseur (7) sont prévus, en ce que le premier redresseur est raccordé par son pôle moins à l'article et par son pôle plus à un premier commutateur (6), en ce que le deuxième redresseur est raccordé par son pôle plus à l'article (2) et par son pôle moins à un deuxième commutateur (8), et en ce que les commutateurs (6, 8), peuvent être commutés en fonction de la période (a, b) souhaitée alternativement sur la première électrode extérieure (3) ou la deuxième électrode extérieure (4).

12. Dispositif selon la revendication 11, caractérisé en ce que la tension de sortie du premier redresseur (5) est supérieure à la tension de sortie du deuxième redresseur (7), en ce que le premier redresseur (5) est commuté sur la première électrode extérieure (3) et le deuxième redresseur (7) sur la deuxième électrode extérieure (4) au cours de la première période (a), et en ce que le premier redresseur (5) est commuté sur la deuxième électrode extérieure (4) et le deuxième redresseur (7) sur la première électrode extérieure (3) au cours de la deuxième période (b).

13. Dispositif selon la revendication 11 ou 12, caractérisé en ce que, au cours de la phase de commutation d'une période (a) à l'autre période (b) et inversement, il est prévu une commande de sorte que la mise en circuit des redresseurs se chevauche dans le temps en ce sens qu'il ne se forme pas d'interruption de courant, c'est-à-dire qu'un courant de maintient circule à travers le bain.

14. Dispositif pour la mise en oeuvre du procédé selon l'une quelconque des revendications 1 à 10, caractérisé en ce qu'il est prévu un premier et un deuxième redresseur, en ce que chacun de ces redresseurs est raccordé électriquement d'une part à l'article et d'autre part à l'une des deux électrodes extérieures, et en ce que, pour la mise en oeuvre des mesures du procédé conformes à l'invention, la polarité respective des redresseurs, l'intensité des courants fournis par chacun d'entre eux et la durée de la fourniture du courant respectif peuvent être réglées chacune individuellement ou en combinaison.

15. Dispositif selon l'une quelconque des revendications 11 à 14, caractérisé en ce que, en supplément du premier et du deuxième redresseur (5) et (7), un ou plusieurs redresseurs de maintien est ou sont prévus pour la conservation d'un courant de maintien pendant toute la durée du traitement.
